# EUROPEAN PATENT APPLICATION

(11) **EP 4 576 203 A1**
(43) Date of publication of application: **25.06.2025**
(21) Application number: 23864435.5
(22) Date of filing: 29.06.2023
(51) Int. Cl.: H01L 23/488

(54) **CHIP PACKAGING STRUCTURE, MANUFACTURING METHOD THEREFOR, AND ELECTRONIC DEVICE**

(30) Priority: 13.09.2022 CN 202211118622
(71) Applicant: Huawei Technologies Co., Ltd., Shenzhen, Guangdong 518129 (CN)
(72) Inventor: WANG, Cheng, Shenzhen, Guangdong 518129 (CN); BAI, Xiaoyang, Shenzhen, Guangdong 518129 (CN); DONG, Jinwen, Shenzhen, Guangdong 518129 (CN)
(74) Representative: Maiwald GmbH
(86) International application number: PCT/CN2023/104026
(87) International publication number: WO 2024/055696

(57) **Abstract**

This application provides a chip package structure and a manufacturing method thereof, and an electronic device, and relates to the field of semiconductor technologies, to reduce a bonding temperature between copper. The chip package structure includes a first chip, a second chip, a first bonding structure disposed on the first chip, and a second bonding structure disposed on the second chip. The first bonding structure includes a first barrier layer, a first seed crystal copper layer, and a first copper structure that are sequentially disposed, the first barrier layer is closer to the first chip than the first copper structure, and the first bonding structure is bonded to the second bonding structure by using the first copper structure. The first copper structure includes a first copper layer and a second copper layer that are sequentially disposed at the first seed crystal copper layer, the first seed crystal copper layer is in contact with the first copper layer, the first copper layer is an electrochemical plating copper layer, and the second copper layer is a physical vapor deposition copper layer. A surface of a side that is of the first copper structure and that is away from the first chip includes at least a part of the physical vapor deposition copper layer.

## Description

This application claims priority to Chinese Patent Application No. 202211118622.5, filed with the China National Intellectual Property Administration on September 13, 2022 and entitled "CHIP PACKAGE STRUCTURE AND MANUFACTURING METHOD THEREOF, AND ELECTRONIC DEVICE", which is incorporated herein by reference in its entirety.

### TECHNICAL FIELD

This application relates to the field of semiconductor technologies, and in particular, to a chip package structure and a manufacturing method thereof, and an electronic device.

### BACKGROUND

A 3D (dimension) integrated circuit (integrated circuit, IC) is defined as a system-level integrated structure in which a plurality of chips are stacked in a vertical plane direction, to save space and meet a higher requirement in the field of semiconductor technologies. Bonding between chips is involved in a 3D IC packaging technology. As key technologies in the 3D IC field, copper-copper direct bonding, hybrid bonding, and the like have a good development prospect.

For bonding manners such as copper-copper direct bonding and hybrid bonding, a bonding connection between copper is involved in a bonding process, and the bonding connection needs to be implemented under a high temperature condition. However, the high temperature condition adversely affects electrical performance of another component in the chip, and even causes damage. For example, in the high temperature condition, copper atom diffusion causes damage to a logic component inside the chip, a cabling structure in a memory component, and the like. This causes electrical and reliability problems of the chip, and even causes a chip failure. Therefore, one of key challenges of the copper-to-copper bonding technology is how to reduce a bonding temperature.

### SUMMARY

This application provides a chip package structure and a manufacturing method thereof, and an electronic device, to reduce a bonding temperature between copper.

This application provides a chip package structure, including a first chip, a second chip, a first bonding structure, and a second bonding structure. The first bonding structure is disposed on the first chip, and the second bonding structure is disposed on the second chip. The first bonding structure includes a first barrier layer, a first seed crystal copper layer, and a first copper structure that are sequentially disposed, the first barrier layer is closer to the first chip than the first copper structure, and the first bonding structure is bonded to the second bonding structure by using the first copper structure. The first copper structure includes a first copper layer and a second copper layer that are sequentially disposed at the first seed crystal copper layer, the first seed crystal copper layer is in contact with the first copper layer, the first copper layer is an electrochemical plating copper layer, and the second copper layer is a physical vapor deposition copper layer. A surface of a side that is of the first copper structure and that is away from the first chip includes at least a part of the physical vapor deposition copper layer.

In the chip package structure provided in this embodiment of this application, a new bonding structure (namely, the first bonding structure) is used. The bonding structure is based on an electrochemical plating (electrochemical plating, ECP) process and a physical vapor deposition (physical vapor deposition, PVD) process, the first copper structure including the electrochemical plating copper (ECP Cu) layer and the physical vapor deposition copper (PVD Cu) layer is formed on a surface of the first seed crystal copper layer, and it is ensured that a bonding surface formed by the first copper structure includes at least a part of the PVD Cu layer. Because the PVD Cu itself has a high proportion of a copper (111) crystal surface, a proportion of a copper (111) crystal surface on the bonding surface of the first bonding structure is increased, a surface diffusion system of the bonding surface is improved, and a bonding temperature is reduced.

In some possible implementations, the first copper structure is in contact with the second bonding structure through the second copper layer. In this case, the physical vapor deposition copper layer is located on the bonding surface, and is directly bonded to the second bonding structure.

In some possible implementations, a surface of a side that is of the first copper layer and that is away from the first chip has a first concave part, and the second copper layer covers the surface of the side that is of the first copper layer and that is away from the first chip. In this case, the first copper structure includes the electrochemical plating copper layer and the physical vapor deposition copper layer that are sequentially disposed on the surface of the first seed crystal copper layer, and is bonded to the second bonding structure through the physical vapor deposition copper layer.

In some possible implementations, a surface of a side that is of the first copper layer and that is away from the first chip has a first concave part; and the first copper structure further includes a middle barrier layer, and the middle barrier layer is located between the first copper layer and the second copper layer. In this case, the first copper structure includes the electrochemical plating copper layer, the middle barrier layer, and the physical vapor deposition copper layer that are sequentially disposed on the surface of the first seed crystal copper layer, and is bonded to the second bonding structure through the physical vapor deposition copper layer. In addition, disposing of the middle barrier layer can reduce impact of a crystal phase structure at the electrochemical plating copper layer (namely, the first copper layer) on a crystal phase of the physical vapor deposition layer (namely, the second copper layer). In this way, the high proportion of the copper (111) crystal surface at the second copper layer can be ensured.

In some possible implementations, a thickness of the second copper layer ranges from 5 nm to 70 nm. In this case, the first concave part may be formed on the surface of the first electrochemical plating copper layer through a chemical mechanical planarization (chemical mechanical planarization, CMP) process. This simplifies a manufacturing process, and avoids a problem of high costs caused by an excessively thick physical vapor deposition layer.

In some possible implementations, the first copper structure further includes a plurality of third copper layers and a plurality of fourth copper layers that are alternately disposed in sequence on a side that is of the second copper layer and that is away from the first chip. The third copper layer is an electrochemical plating copper layer, and the fourth copper layer is a physical vapor deposition copper layer. In the plurality of third copper layers and the plurality of fourth copper layers, a film layer that is in contact with the second copper layer is the third copper layer, and a film layer that is farthest away from the first chip is the fourth copper layer.

In some possible implementations, a thickness of the third copper layer is less than or equal to 3000 Å. In this case, a severe crystal phase loss of the electrochemical plating copper layer (namely, the third copper layer) can be avoided, and it is ensured that the electrochemical plating copper layer itself has a high proportion of a copper (111) crystal phase.

In some possible implementations, the first seed crystal copper layer is a physical vapor deposition copper layer.

In some possible implementations, the first barrier layer includes one or more of Ta, TaN, TaSiN, and TaSi_{0.10}N_{0.57}.

In some possible implementations, surface roughness of the first barrier layer is less than 20 nm.

In some possible implementations, surface roughness of a first dielectric layer is less than 1 nm.

In some possible implementations, the chip package structure further includes the first dielectric layer, and the first dielectric layer is disposed on a surface of the first chip; and the first bonding structure is a bonding layer disposed on a side that is of the first dielectric layer and that is away from the first chip. In other words, the first chip and the second chip in the chip package structure use copper-copper direct bonding.

In some possible implementations, the chip package structure further includes the first dielectric layer; and the first dielectric layer is disposed on a surface of the first chip, a plurality of first trenches are disposed at the first dielectric layer, and the first bonding structure is a bonding contact disposed in the first trench. In other words, the first chip and the second chip in the chip package structure use hybrid bonding.

In some possible implementations, the second bonding structure includes a second barrier layer, a second seed crystal copper layer, and a second copper structure that are sequentially disposed, the second barrier layer is closer to the second chip than the second copper structure, and the second copper structure is bonded to the first copper structure. The second copper structure includes a fifth copper layer and a sixth copper layer that are sequentially disposed at the second seed crystal copper layer, and the fifth copper layer is in contact with the second seed crystal copper layer. The fifth copper layer is an electrochemical plating copper layer, and the sixth copper layer is a physical vapor deposition copper layer.

In some possible implementations, disposing structures of the second bonding structure and the first bonding structure are the same.

In some possible implementations, the second bonding structure includes a second barrier layer, a second seed crystal copper layer, and a second copper structure that are sequentially disposed; and the second barrier layer is closer to the second chip than the second copper structure, the second copper structure is an electrochemical plating copper layer, and the second copper structure is bonded to the first copper structure.

An embodiment of this application further provides chip package structure manufacturing method, including: providing a first chip, and sequentially forming a first barrier layer and a first seed crystal copper layer on the first chip; manufacturing a first copper structure on a surface of the first seed crystal copper layer through a physical vapor deposition process and an electrochemical plating process, to form a first copper bonding structure, where a surface of a side that is of the first copper structure and that is away from the first chip includes at least a part of a physical vapor deposition copper layer; and bonding the first chip to a second copper bonding structure on a second chip by using the first copper structure in the first copper bonding structure.

According to the chip package structure manufacturing method provided in this embodiment of this application, the first copper structure is formed on the surface of the first seed crystal copper layer based on the electrochemical plating (ECP) process and the physical vapor deposition (PVD) process, and it is ensured that a bonding surface formed by the first copper structure includes at least a part of the PVD Cu. Because the PVD Cu itself has a high proportion of a copper (111) crystal surface, a proportion of a copper (111) crystal surface on the bonding surface of the first bonding structure is increased, a surface diffusion system of the bonding surface is improved, and a bonding temperature is reduced.

In some possible implementations, the manufacturing a first copper structure on a surface of the first seed crystal copper layer through a physical vapor deposition process and an electrochemical plating process, to form a first copper bonding structure may include: manufacturing a first copper layer on the surface of the first seed crystal copper layer through the electrochemical plating process, and forming a first concave part on a surface of the first copper layer; and manufacturing a second copper layer on the surface of the first copper layer through the physical vapor deposition process, to form the first copper structure.

In some possible implementations, the manufacturing a first copper structure on a surface of the first seed crystal copper layer through a physical vapor deposition process and an electrochemical plating process, to form a first copper bonding structure may include: manufacturing a first copper layer on the surface of the first seed crystal copper layer through the electrochemical plating process, and forming a first concave part on a surface of the first copper layer; and manufacturing a middle barrier layer on the surface of the first copper layer, and manufacturing a second copper layer on a surface of the middle barrier layer through the physical vapor deposition process, to form the first copper structure.

In some possible implementations, the manufacturing a first copper structure on a surface of the first seed crystal copper layer through a physical vapor deposition process and an electrochemical plating process, to form a first copper bonding structure may include: alternatively manufacturing a plurality of copper layers on the surface of the first seed crystal copper layer through the electrochemical plating process and the physical vapor deposition process, to form the first copper structure.

In some possible implementations, the providing a first chip, and sequentially forming a first barrier layer and a first seed crystal copper layer on the first chip may include: providing the first chip, and forming a first dielectric layer on a surface of the first chip; and sequentially forming the first barrier layer and the first seed crystal copper layer on a surface of the first dielectric layer.

In some possible implementations, the providing a first chip, and sequentially forming a first barrier layer and a first seed crystal copper layer on the first chip may include: providing the first chip, forming a first dielectric layer on a surface of the first chip, and forming a plurality of first trenches at the first dielectric layer; and sequentially forming the first barrier layer and the first seed crystal copper layer in the first trench.

An embodiment of this application further provides an electronic device. The electronic device includes a printed circuit board and the chip package structure provided in any one of the foregoing possible implementations, and the chip package structure is electrically connected to the printed circuit board.

### BRIEF DESCRIPTION OF DRAWINGS

FIG. 1 is a diagram of a chip package structure according to an embodiment of this application;
FIG. 2 is a diagram of a chip package structure according to an embodiment of this application;
FIG. 3 is a diagram of a bonding structure according to an embodiment of this application;
FIG. 4 is a diagram of a crystal phase structure in which an electrochemical plating copper layer is grown at a physical vapor deposition copper layer;
FIG. 5 is a diagram of a copper bonding structure according to an embodiment of this application;
FIG. 6 is a diagram of a copper bonding structure according to an embodiment of this application;
FIG. 7 is a flowchart of a manufacturing manner of a chip package structure according to an embodiment of this application;
FIG. 8 is diagram of a manufacturing process of a chip package structure according to an embodiment of this application;
FIG. 9 is diagram of a manufacturing process of a chip package structure according to an embodiment of this application;
FIG. 10 is diagram of a manufacturing process of a chip package structure according to an embodiment of this application;
FIG. 11 is a diagram of a copper bonding structure according to an embodiment of this application;
FIG. 12 is a flowchart of a manufacturing manner of a chip package structure according to an embodiment of this application;
FIG. 13 is diagram of a manufacturing process of a chip package structure according to an embodiment of this application;
FIG. 14 is a diagram of a copper bonding structure according to an embodiment of this application;
FIG. 15 is a diagram of a copper bonding structure according to an embodiment of this application;
FIG. 16 is a flowchart of a manufacturing manner of a chip package structure according to an embodiment of this application;
FIG. 17 is a diagram of a copper bonding structure according to an embodiment of this application; and
FIG. 18 is a flowchart of a manufacturing manner of a chip package structure according to an embodiment of this application.

### DESCRIPTION OF EMBODIMENTS

To make objectives, technical solutions, and advantages of this application clearer, the following clearly and completely describes the technical solutions in this application with reference to accompanying drawings in this application. It is clear that described embodiments are some but not all of embodiments of this application. All other embodiments obtained by a person of ordinary skill in the art based on embodiments of this application without creative efforts shall fall within the protection scope of this application.

In the specification, embodiments, claims, and accompanying drawings of this application, terms "first", "second", and the like are merely used for distinguishing and description, and should not be understood as indicating or implying relative importance, or should not be understood as indicating or implying a sequence. A term "and/or" is used to describe an association relationship between associated objects, and indicates that three relationships may exist. For example, "A and/or B" may indicate the following three cases: Only A exists, only B exists, and both A and B exist, where A and B may be singular or plural. A character "/" usually indicates an "or" relationship between the associated objects. "At least one piece (item)" means one or more, and "a plurality of" means two or more. "Installation", "connection", "being connected to", and the like should be understood in a broad sense, for example, may be a fixed connection, a detachable connection, or an integral connection; or may be a direct connection, an indirect connection through an intermediate medium, or internal communication between two elements. In addition, terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device. "Up", "down", "left", "right", and the like are used only relative to orientations of components in the accompanying drawings. These directional terms are relative concepts, are used for relative description and clarification, and may change correspondingly based on a change in an orientation in which the component is placed in the accompanying drawings.

An embodiment of this application provides an electronic device. The electronic device includes a printed circuit board (printed circuit board, PCB) and a chip package structure. The chip package structure is disposed on a surface of the printed circuit board (which may also be referred to as a circuit board), and the chip package structure is electrically connected to the printed circuit board.

A form in which the electronic device is disposed is not limited in this application. For example, the electronic device may be an electronic product like a mobile phone, a tablet computer, a notebook computer, a vehicle-mounted computer, a smartwatch, or a smart band.

A form in which the chip package structure is disposed is not limited in this application. For example, the chip package structure may include a processor, a memory, and the like.

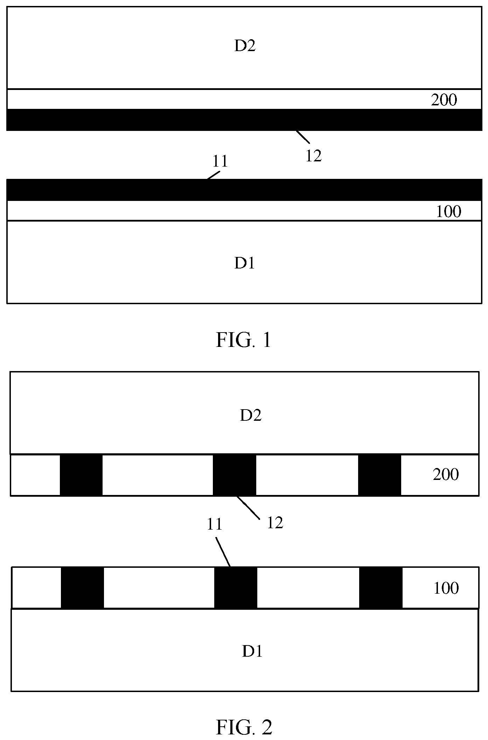

For example, in this application, the chip package structure may be a 3D package structure. As shown in FIG. 1 and FIG. 2, the chip package structure may include a first chip D1 and a second chip D2 that are stacked. A first bonding structure 11 is disposed on the first chip D1, a second bonding structure 12 is disposed on the second chip D2, and the first chip D1 and the second chip D2 are bonded by using the first bonding structure 11 and the second bonding structure 12. Bonding surfaces of the first bonding structure 11 and the second bonding structure 12 each include copper. In this case, bonding between the first bonding structure 11 and the second bonding structure 12 includes a connection between the copper (which may be referred to as a copper-copper connection for short below).

It may be understood that the copper-copper connection in bonding means bonding between the copper in the bonding technology. For a manner of bonding between the first chip D1 and the second chip D2, the copper-copper connection may be copper-copper direct bonding shown in FIG. 1, or may be hybrid bonding shown in FIG. 2. This is not limited in this application.

Certainly, in different bonding manners, forms in which the bonding structures (11 and 12) are disposed may be different to some extent.

For the copper-copper direct bonding in FIG. 1, the bonding structures (11 and 12) each include a copper bonding layer. In this case, the first chip D1 and the second chip D2 are bonded by using the copper bonding layers.

For the hybrid bonding in FIG. 2, the bonding structures (11 and 12) each include a copper bonding contact. In this case, the first chip D1 and the second chip D2 are bonded through the copper bonding contacts.

Certainly, for the hybrid bonding, in addition to bonding between the copper bonding contacts, bonding between an insulator and an insulator that are located on side surfaces of the copper bonding contacts may be further included. This is not limited in this application.

It should be further understood that, for the bonding connection between the copper, a bonding principle is surface diffusion of a copper crystal surface. A larger surface diffusion system of the copper crystal surface indicates a lower bonding temperature between the copper. A copper surface may be classified into three types of crystal surfaces: (111), (110), and (100). A surface diffusion coefficient of the (111) crystal surface is three to four orders of magnitude greater than those of the (110) crystal surface and the (100) crystal surface. Therefore, by increasing a proportion of the (111) crystal surface of the copper surface, the bonding temperature between the copper can be greatly reduced, bonding time can be shortened, and effect of mutual melting between the copper can be improved. This can ensure an electrical property, a reliability test result, and the like of the chip.

In addition, by increasing the proportion of the (111) crystal surface of the copper surface, an oxidation resistance capability, electrical mobility, and a chemical mechanical planarization (chemical mechanical planarization, CMP) scratch resistance capability of the copper surface can also be greatly enhanced.

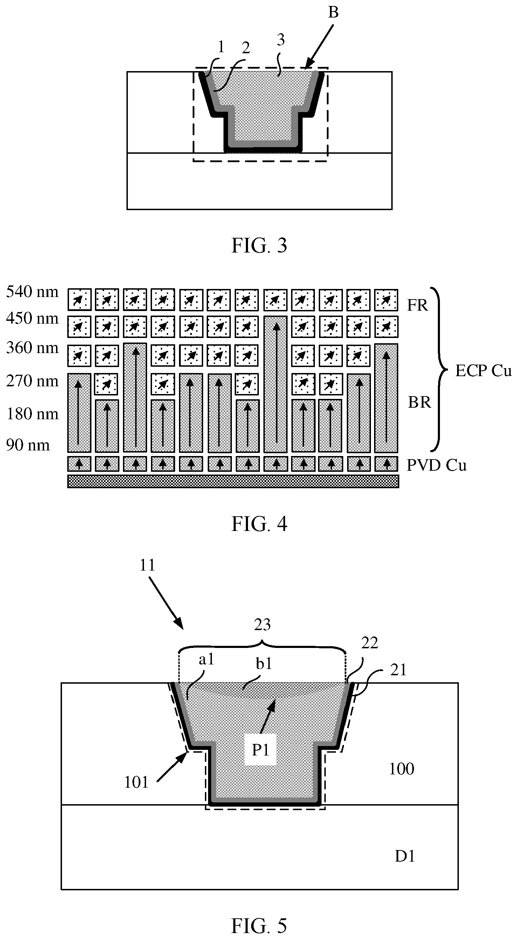

FIG. 3 is a diagram of a bonding structure in a related technology according to this application. As shown in FIG. 3, in the related technology of this application, a bonding structure B includes a barrier layer 1, a seed crystal copper layer 2, and an electrochemical plating copper layer 3 that are sequentially disposed from bottom to top (namely, in a direction away from a substrate). The seed crystal copper layer 2 may also be referred to as a seed layer, and is manufactured through a physical vapor deposition (physical vapor deposition, PVD) process. The electrochemical plating copper layer 3 is manufactured through an electrochemical plating (electrochemical plating, ECP) process. A surface of the electrochemical plating copper layer 3 in the bonding structure B is used as a bonding surface for bonding.

FIG. 4 is a diagram of a crystal phase structure in which an electrochemical plating copper (ECP Cu) layer is grown at a physical vapor deposition copper (PVD Cu) layer. Refer to FIG. 4. The PVD Cu is used as a seed crystal copper layer, and may have a copper (111) crystal surface proportion of more than 90%, for example, about 97%. In a process of depositing the ECP Cu from bottom to top on a surface of the PVD Cu, as a thickness of the deposited ECP Cu film increases, the copper (111) crystal phase changes from basis-oriented (basis oriented, BR) growth to field-oriented (field oriented, FR) growth, resulting in a gradual loss of the copper (111) crystal phase.

In other words, for the bonding structure B in FIG. 3, the electrochemical plating copper layer 3 is formed at the seed crystal copper layer 2 (PVD Cu). As the deposition thickness of the electrochemical plating copper layer 3 increases, the copper (111) crystal phase is lost. As a result, a proportion of a copper (111) crystal surface on the bonding surface of a bonding structure 20 is very low, and it is difficult to complete bonding at a low bonding temperature.

In view of this, in a chip package structure provided in embodiments of this application, a new bonding structure is used. The bonding structure includes a barrier layer and a seed crystal copper layer that are sequentially disposed, a copper structure including an electrochemical plating copper (ECP Cu) layer and a physical vapor deposition copper (PVD Cu) layer is formed on a surface of the seed crystal copper layer based on an ECP process and a PVD process, and a bonding surface formed by the copper structure includes at least a part of the PVD Cu. Because the PVD Cu itself has a high proportion of a copper (111) crystal surface, a proportion of a copper (111) crystal surface on the bonding surface of the bonding structure can be increased, a surface diffusion system of the bonding surface is improved, and a bonding temperature is reduced.

The following describes, by using specific embodiments, a new bonding structure used in the chip package structure provided in this application.

### Embodiment 1

Embodiment 1 provides a chip package structure. Refer to FIG. 2. The chip package structure includes a first chip D1 and a second chip D2, and the first chip D1 and the second chip D2 are connected through hybrid bonding.

In this application, the first chip D1 may be a wafer (wafer), or may be a die (die). Similarly, the second chip D2 may be a wafer, or may be a die. In other words, bonding between the first chip D1 and the second chip D2 may be bonding between wafers, bonding between dies, or bonding between a die and a wafer. This is not limited in this application.

For example, refer to FIG. 5. A first dielectric layer 100 is disposed on the first chip D1, a first trench 101 is disposed at the first dielectric layer 100, and a first bonding structure 11 is disposed in the first trench 101 as a copper bonding contact. The first bonding structure 11 includes a first barrier layer 21, a first seed crystal copper layer 22, and a first copper structure 23 that are sequentially disposed from bottom to top. The first chip D1 is bonded to a second bonding structure 12 through an upper surface of the first copper structure 23, in other words, the upper surface of the first copper structure 23 is used as a bonding surface of the first bonding structure 11.

A shape of the first trench 101 is not limited in this application, and may be set based on a requirement in practice. For example, in some possible implementations, as shown in FIG. 5, the first trench 101 may be a trench of a dual Damascus structure. For another example, in some possible implementations, the first trench 101 may be a trench of a single Damascus structure, that is, a cross section of the first trench 101 is in an inverted trapezoid shape.

The following separately describes specific disposing of the first barrier layer 21, the first seed crystal copper layer 22, and the first copper structure 23.

Selection of the first dielectric layer 100 is related to adhesion of a dielectric film layer below the first dielectric layer 100 and stress of the first dielectric layer 100. In addition, surface roughness of the first dielectric layer 100 further needs to be considered during selection of the first dielectric layer 100. Therefore, an appropriate material may be selected, to ensure that the surface roughness of the first dielectric layer 100 is less than 1 nm while meeting a requirement of the first dielectric layer 100.

For example, in some possible implementations, the material for forming the first dielectric layer 100 may include one or more of SiC:H (hydrogenated silicon carbide), silicon carbon nitride (SiCN), silicon oxide (SixOy), and silicon nitride (SixNy).

The first barrier layer 21 is disposed to prevent a copper atom in the first bonding structure 11 from diffusing into the first dielectric layer 100, to avoid electrical and reliability problems and the like of the chip. In addition, considering that surface roughness of the first barrier layer 21 directly affects a proportion of a copper (111) crystal phase in the subsequently formed first seed crystal copper layer 22, an appropriate material may be selected, to ensure that the surface roughness of the first barrier layer 21 is less than 20 nm while meeting a requirement of the first barrier layer 21.

For example, in some possible implementations, the material for forming the first barrier layer 21 may include one or more of Ta, TaN, TaSiN, and TaSi_{0.10}N_{0.57}, where TaN may include at least one of a-TaN and c-TaN. This is not limited in this application.

As a seed layer, the first seed crystal copper layer 22 itself has a high-proportion copper (111) crystal surface, is used as an adhesive between the first barrier layer and a subsequently formed copper layer (ECP Cu), and is used to implement basis-oriented growth for the subsequent copper layer.

For example, in some possible implementations, the first seed crystal copper layer 22 may be manufactured through a PVD process, that is, the first seed crystal copper layer 22 may be a physical vapor deposition copper (PVD Cu) layer.

For disposing of the first copper structure 23,
refer to FIG. 5. In some possible implementations, the first copper structure 23 may include a first electrochemical plating copper layer a1 (which may also be referred to as a first copper layer or a first ECP Cu layer) and a first physical vapor deposition copper layer b1 (which may also be referred to as a second copper layer or a second PVD Cu layer). The first electrochemical plating copper layer a1 is in direct contact with a surface of the first seed crystal copper layer 22, and an upper surface (namely, a surface of a side away from the first chip D1) of the first electrochemical plating copper layer a1 has a first concave part P1. The first physical vapor deposition copper layer b1 covers the upper surface of the first electrochemical plating copper layer a1, and fills the first concave part P1. In this case, the first physical vapor deposition copper layer b1 is directly used as a part or all of the bonding surface of the first bonding structure 11, and is bonded to the second bonding structure 12.

Compared with the bonding surface of the bonding structure B in FIG. 3 that is the electrochemical plating copper (ECP Cu) layer and that has the low proportion of the copper (111) crystal surface, in Embodiment 1 of this application, based on that the physical vapor deposition copper (PVD Cu) layer itself has a high proportion of a copper (111) crystal surface, a part or all of the bonding surface of the first bonding structure 11 is disposed as the physical vapor deposition copper (PVD Cu) layer, so that the proportion of the copper (111) crystal surface on the bonding surface is increased, a surface diffusion system of the bonding surface is improved, and a bonding temperature is reduced.

A shape, a size, and the like of the first concave part P1 are not limited in this application, and may be set based on a requirement in practice.

For example, refer to FIG. 5. In some possible implementations, a disc-shaped concave part (P1) is formed on the upper surface of the first electrochemical plating copper layer a1 as a whole. In this case, the first physical vapor deposition layer b1 filled in the disc-shaped concave part (P1) is used as almost all of the bonding surface.

In addition, a thickness of the first physical vapor deposition copper layer b1 is not limited in this application.

For example, in some possible implementations, considering a manufacturing process and manufacturing costs, for example, a manufacturing depth of the first concave part P1 is limited by a process and high manufacturing costs of the physical vapor deposition layer, the thickness of the first physical vapor deposition layer b1 may be set to be within a range of 5 nm to 70 nm, that is, a thickness of the first physical vapor deposition layer b1 covering a deepest position of the first concave part P1 is within a range of 5 nm to 70 nm. In this case, a first concave part 101 may be formed on the surface of the first electrochemical plating copper layer a1 through a chemical mechanical planarization (chemical mechanical planarization, CMP) process. This simplifies a manufacturing process, and avoids a problem of high costs caused by an excessively thick physical vapor deposition layer.

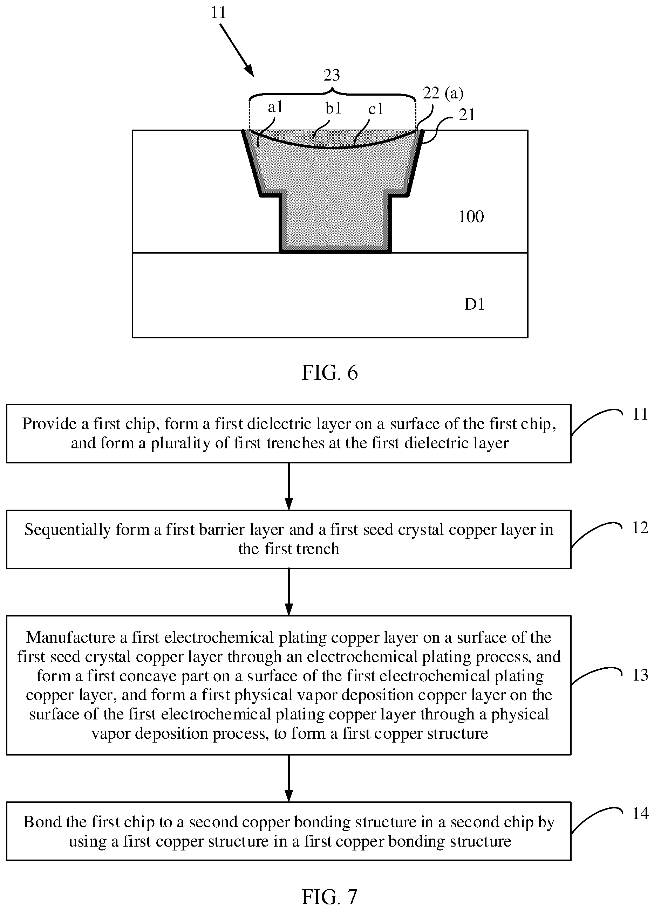

In addition, in the first copper structure 23, if a thickness of the first electrochemical plating copper layer a1 is large, a free-growing crystal phase structure on the surface of the first electrochemical plating copper layer a1 causes a decrease in the proportion of the copper (111) crystal surface at the first physical vapor deposition layer b1. Therefore, as shown in FIG. 6, in some possible implementations, a first middle barrier layer c1 may be disposed between the first electrochemical plating copper layer a1 and the first physical vapor deposition layer b1. In this way, impact of the crystal phase structure at the first electrochemical plating copper layer a1 on the crystal phase of the first physical vapor deposition layer b1 can be reduced by using a blocking function of the first middle barrier layer c1. In this way, the high proportion of the copper (111) crystal surface at the first physical vapor deposition layer b1 can be ensured.

It should be noted that, as shown in FIG. 1 and FIG. 2, disposing of the second bonding structure 12 disposed on the second chip D2 is not limited in this application, and the second bonding structure 12 may be selected and disposed based on a requirement in practice.

For example, in some possible implementations, the first bonding structure 11 may use the bonding structure shown in FIG. 5 or FIG. 6, and the second bonding structure 12 may use the bonding structure B shown in FIG. 3. In this case, the second bonding structure 12 includes the barrier layer 1, the seed crystal copper layer 2, and the electrochemical plating copper layer 3 that are sequentially disposed from bottom to top.

For another example, in some possible implementations, both the first bonding structure 11 and the second bonding structure 12 may use the bonding structure shown in FIG. 5 or FIG. 6.

Certainly, in consideration of stability of bonding between the first bonding structure 11 and the second bonding structure 12, in some possible implementations, the first bonding structure 11 and the second bonding structure 12 may be disposed to use a same structure.

For example, in some possible implementations, when the first bonding structure 11 includes the first barrier layer 21, the first seed crystal copper layer 22, the first electrochemical plating copper layer a1, and the first physical vapor deposition copper layer b1 that are sequentially disposed from bottom to top (FIG. 5), the second bonding structure 12 may be disposed to include a second barrier layer, a second seed crystal copper layer, and a second electrochemical plating copper layer (which may also be referred to as a fifth copper layer), and a second physical vapor deposition copper layer (which may also be referred to as a sixth copper layer). Disposing of the second barrier layer, the second seed crystal copper layer, the second electrochemical plating copper layer, and the second physical vapor deposition copper layer is basically the same as disposing of the first barrier layer 21, the first seed crystal copper layer 22, the first electrochemical plating copper layer a1, and the first physical vapor deposition copper layer b1. For related content, refer to the foregoing descriptions. Details are not described herein again.

For another example, in some possible implementations, when the first bonding structure 11 includes the first barrier layer 21, the first seed crystal copper layer 22, the first electrochemical plating copper layer a1, the first middle barrier layer c1, and the first physical vapor deposition copper layer b1 that are sequentially disposed from bottom to top (FIG. 6), the second bonding structure 12 may include the second barrier layer, the second seed crystal copper layer, the second electrochemical plating copper layer (which may also be referred to as the fifth copper layer), a second middle barrier layer, and the second physical vapor deposition copper layer (which may also be referred to as the sixth copper layer) that are sequentially disposed from bottom to top. Disposing of the second barrier layer, the second seed crystal copper layer, the second electrochemical plating copper layer, the second middle barrier layer, and the second physical vapor deposition copper layer is basically the same as the disposing of the first barrier layer 21, the first seed crystal copper layer 22, the first electrochemical plating copper layer a1, the first middle barrier layer c1, and the first physical vapor deposition copper layer b1. For related content, refer to the foregoing descriptions. Details are not described herein again.

Certainly, disposing other than that of the first bonding structure 11 and the second bonding structure 12 in the chip package structure is not limited in this application. In practice, disposing may be performed based on a requirement. For example, refer to FIG. 1 and FIG. 2. Materials of the first dielectric layer 100 located on the first chip D1 and a second dielectric layer 200 located on the second chip D2 may be the same or may be different, provided that the materials are specifically set based on an actual requirement. This is not limited in this application.

The following describes, with reference to a chip package structure manufacturing method, manufacturing of the new bonding structure provided in Embodiment 1.

For example, Embodiment 1 provides a chip package structure manufacturing method. As shown in FIG. 7, the manufacturing method includes the following steps.

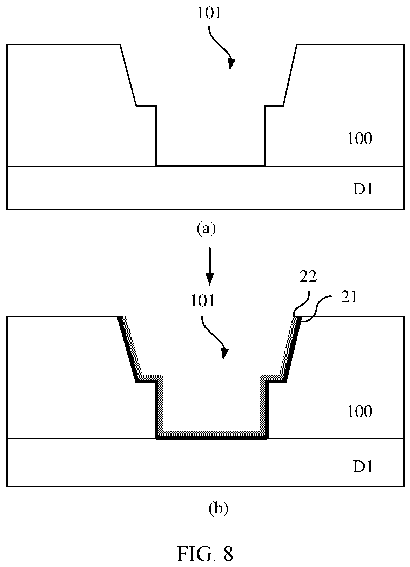

Step 11: Provide the first chip D1, form the first dielectric layer 100 on a surface of the first chip D1, and form a plurality of first trenches 101 at the first dielectric layer 100, as shown in (a) in FIG. 8.

The first chip D1 may be the wafer, the die, or the like. A required film layer may be disposed on the surface of the first chip D1 based on a requirement, and an electronic component, an interconnection cable, and the like are disposed inside the first chip D1 based on a requirement.

For example, in some possible implementations, step 11 may include: Provide the first chip D1, then form the first dielectric layer 100 on the surface of the first chip D1 by using the SiC:H material, and next, form the plurality of first trenches 101 of the dual Damascus structure at the first dielectric layer 100, as shown in (a) in FIG. 8.

Step 12: Sequentially form the first barrier layer 21 and the first seed crystal copper layer 22 in the first trench 101, as shown in (b) in FIG. 8.

For example, in some possible implementations, step 12 may include: Deposit TaSiN in the first trench 101 through the PVD process, to form the first barrier layer 21, and then form the first seed crystal copper layer 22 on a surface of the first barrier layer 21 through the PVD process, as shown in (b) in FIG. 8.

In addition, in some possible implementations, in a process of forming the first seed crystal copper layer 22 through deposition through the PVD process, a Cu+/Ar ion beam bombardment manner may be used to reduce an overhang (overhang) part at an opening of the first trench 101, reduce a risk of a void (void) in a subsequent deposition process, and further obtain a flatter first seed crystal copper layer 22.

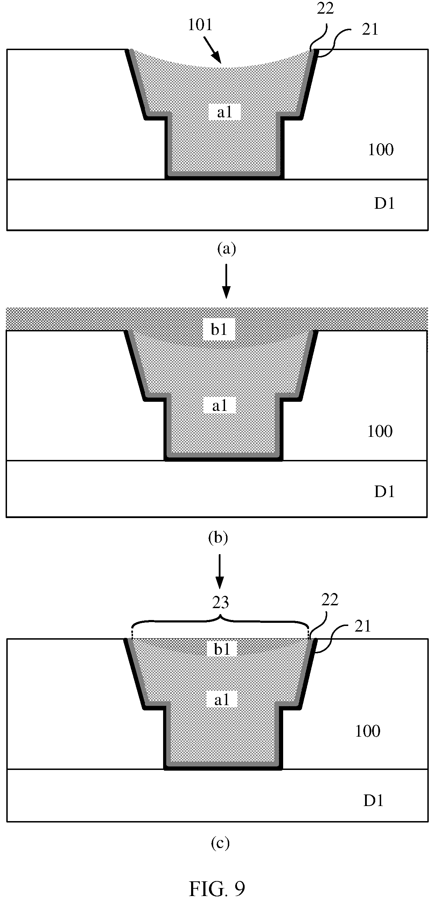

Step 13: Manufacture the first electrochemical plating copper layer a1 on the surface of the first seed crystal copper layer 22 through an electrochemical plating process, and form the first concave part on the surface of the first electrochemical plating copper layer a1; and manufacture the first physical vapor deposition copper layer b1 on the surface of the first electrochemical plating copper layer a1 through the physical vapor deposition process, to form the first copper structure 23, as shown in FIG. 9.

For example, in some possible implementations, step 13 may include: Manufacture the first electrochemical plating copper layer a1 on the surface of the first seed crystal copper layer 22 through the ECP process, and form the first concave part 101 on the surface of the first electrochemical plating copper layer a1 through the chemical mechanical planarization (CMP) process, as shown in (a) in FIG. 9; and then form the first physical vapor deposition copper layer b1 having the thickness of about 5 nm to 70 nm on the surface of the first electrochemical plating copper layer a1 through the PVD process, and grind the first physical vapor deposition copper layer b1 through the chemical mechanical planarization (CMP) process to expose the first dielectric layer 100. In this case, the first electrochemical plating copper layer a1 and the first physical vapor deposition copper layer b1 form the first copper structure 23, as shown in (b) and (c) in FIG. 9.

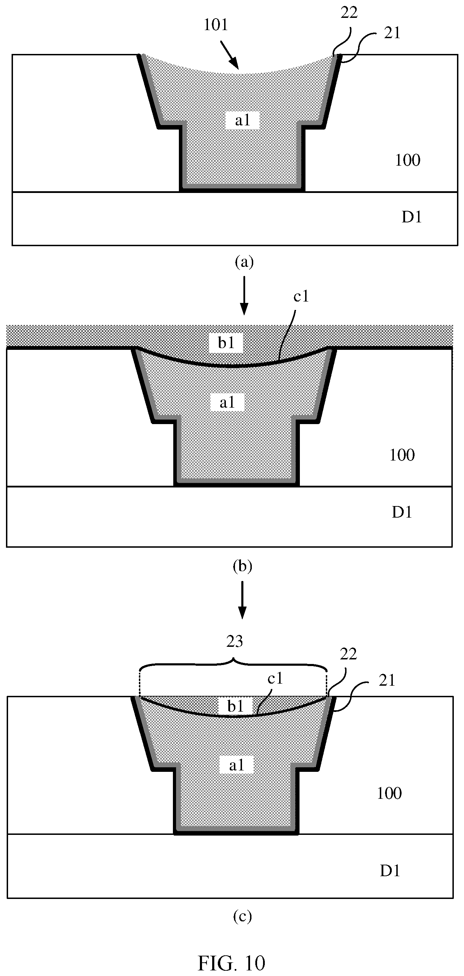

Certainly, for manufacturing of the first copper structure 23 including the first middle barrier layer c1 in FIG. 6, refer to FIG. 10. A difference between the manufacturing of the first copper structure 23 and step 13 lies only in that before the first physical vapor deposition copper layer b1 is formed, the first middle barrier layer c1 is first formed on the surface of the first electrochemical plating copper layer a1, and then the first physical vapor deposition copper layer b1 is formed on the surface of the first middle barrier layer c1. In this case, the first electrochemical plating copper layer a1, the first middle barrier layer c1, and the first physical vapor deposition copper layer b1 form the first copper structure 23.

Step 14: Bond the first chip D1 to the second copper bonding structure 12 in the second chip D2 by using the first copper structure 23 in the first copper bonding structure 11, with reference to FIG. 2 and (c) in FIG. 9.

In the ECP process used in this embodiment of this application, related electroplating parameters such as a current density, a current output mode, an electroplating rotational speed, and an electroplating temperature may be set based on an actual requirement. This is not limited in this application.

### Embodiment 2

Embodiment 2 provides a chip package structure. A new first bonding structure 11 is used in the chip package structure, and a difference between the chip package structure and the first bonding structure 11 in Embodiment 1 lies only in that a disposing structure of the first copper structure 23 is different.

The following describes the first copper structure 23 in the chip package structure provided in Embodiment 2. For other parts in the chip package structure, refer to the related content in Embodiment 1. Details are not described herein again.

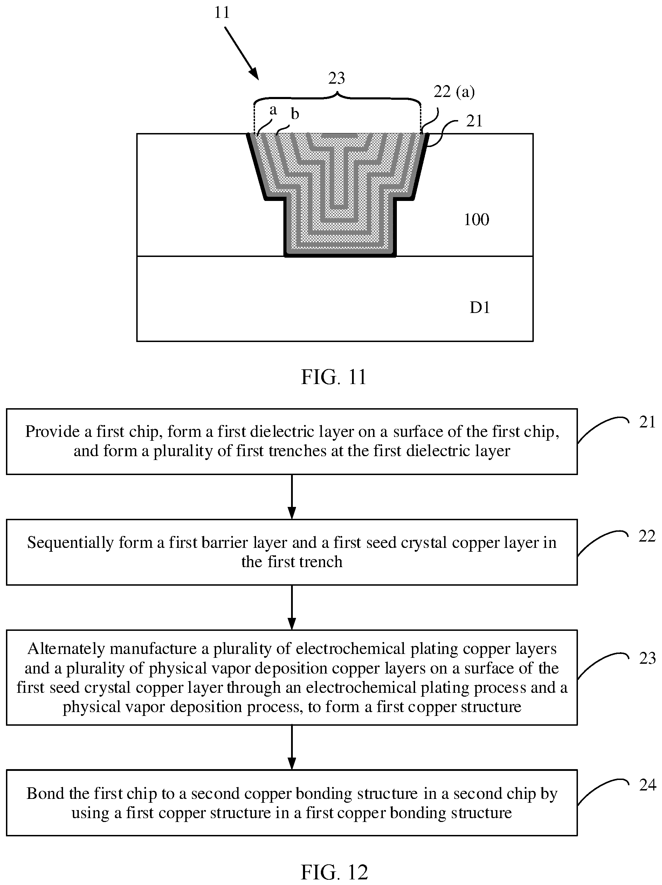

As shown in FIG. 11, in Embodiment 2, the first copper structure 23 includes a plurality of electrochemical plating copper layers a and a plurality of physical vapor deposition copper layers b that are alternately disposed in sequence on the surface of the first seed crystal copper layer 22.

In the first copper structure 23, the first seed crystal copper layer 22 is in contact with the electrochemical plating copper layer a, and a film layer located at a top layer is the physical vapor deposition copper layer b, that is, in the first copper structure 23, the first formed copper layer is the electrochemical plating copper layer a, and the last formed copper layer is the physical vapor deposition copper layer b. In this case, the last formed physical vapor deposition copper layer b is located on the bonding surface, so that the proportion of the copper (111) crystal surface on the bonding surface is increased, the surface diffusion system of the bonding surface is improved, and the bonding temperature is reduced.

For the plurality of electrochemical plating copper layers a and the plurality of physical vapor deposition copper layers b that are alternately disposed, the electrochemical plating copper layer a that is in contact with the first seed crystal copper layer 22 may be referred to as a first copper layer, the physical vapor deposition copper layer b that is located on a surface of the first copper layer may be referred to as a second copper layer, all electrochemical plating copper layers a that are located after the second copper layer may be referred to as a third copper layer, and all physical vapor deposition copper layers b that are located after the second copper layer may be referred to as a fourth copper layer.

Certainly, it may be understood that, when the ECP Cu and the PVD Cu are alternately deposited in the first trench 101, a ring-shaped alternating interface of the ECP Cu and the PVD Cu is presented on the bonding surface of the first bonding structure 11.

In addition, in this embodiment, when the electrochemical plating copper layer a and the physical vapor deposition copper layer b are alternately disposed, a thickness of the electrochemical plating copper layer a can be controlled to reduce a loss of a copper (111) crystal phase caused by an excessively large thickness of the electrochemical plating copper layer a. In this way, the high proportion of the copper (111) crystal phase at the electrochemical plating copper layer a in the first copper structure 23 can be ensured, and further the high proportion of the copper (111) crystal phase on the bonding surface of the first bonding structure 11 can be ensured.

For example, in some possible implementations, the thickness of the electrochemical plating copper layer a may be less than or equal to 3000 Å, to avoid a severe crystal phase loss of the electrochemical plating copper layer a, ensure that the electrochemical plating copper layer a itself has the high proportion of the copper (111) crystal phase, and further ensure that the physical vapor deposition copper layer b on the surface of the electrochemical plating copper layer a has a high proportion of a copper (111) crystal phase.

For example, Embodiment 2 further provides a chip package structure manufacturing method. As shown in FIG. 12, the manufacturing method includes the following steps.

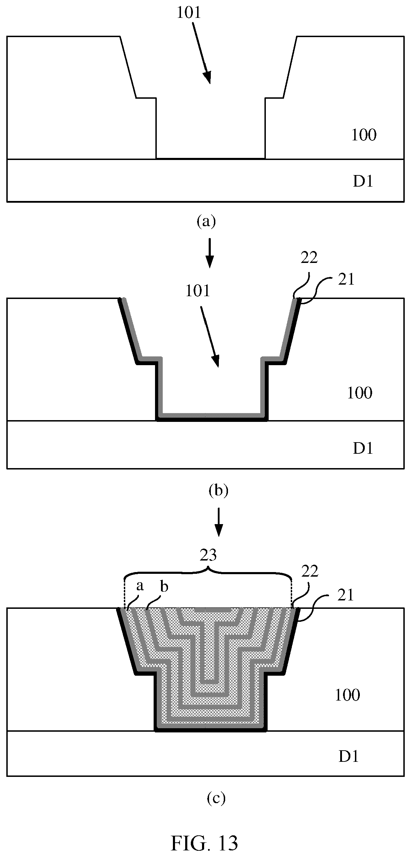

Step 21: Provide the first chip D1, form the first dielectric layer 100 on the surface of the first chip D1, and form the plurality of first trenches 101 at the first dielectric layer 100, as shown in (a) in FIG. 13.

Step 21 is basically the same as step 11 in Embodiment 1. For details, refer to the related content in step 11. Details are not described herein again.

Step 22: Sequentially form the first barrier layer 21 and the first seed crystal copper layer 22 in the first trench 101, as shown in (b) in FIG. 13.

Step 22 is basically the same as step 12 in Embodiment 1. For details, refer to the related content in step 12. Details are not described herein again.

Step 23: Alternately manufacture the plurality of electrochemical plating copper layers a and the plurality of physical vapor deposition copper layers b on the surface of the first seed crystal copper layer 22 through the electrochemical plating process and the physical vapor deposition process, to form the first copper structure 23, as shown in (c) in FIG. 13.

For example, in some possible implementations, step 23 may include: First form, on the surface of the first seed crystal copper layer 22 through the ECP process, the electrochemical plating copper layer a having the thickness less than 3000 Å, and then form the physical vapor deposition copper layer b through the PVD process, which is alternately performed for a plurality of times, as shown in (c) in FIG. 13.

Step 24: Bond the first chip D1 to the second copper bonding structure in the second chip D2 by using the first copper structure 23 in the first copper bonding structure, with reference to FIG. 2 and (c) in FIG. 13.

### Embodiment 3

Different from the hybrid bonding used in the chip package structure in Embodiment 1, a chip package structure provided in Embodiment 3 uses a copper-copper direct bonding connection.

In Embodiment 3, as shown in FIG. 1, the chip package structure includes the first chip D1 and the second chip D2, and the first chip D1 and the second chip D2 are connected through copper-copper direct bonding.

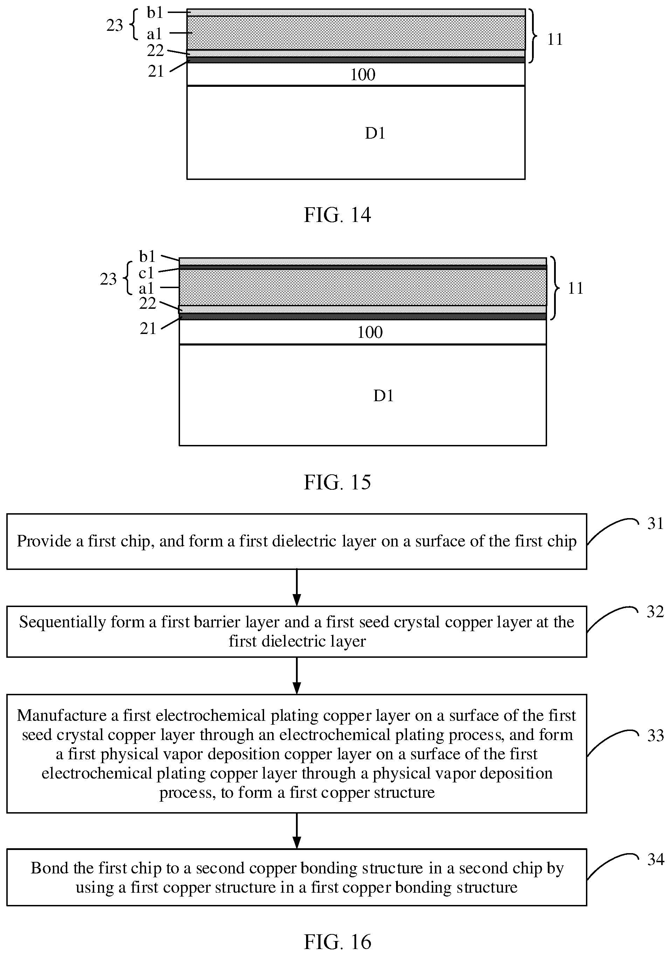

Refer to FIG. 14. The first dielectric layer 100 is disposed on the first chip D1, and the first barrier layer 21, the first seed crystal copper layer 22, and the first copper structure 23 are sequentially disposed on the surface of the first dielectric layer 100 from bottom to top. The first copper structure 23 includes the first electrochemical plating copper layer a1 and the first physical vapor deposition copper layer b1. The first electrochemical plating copper layer a1 is in direct contact with the surface of the first seed crystal copper layer 22, and the first physical vapor deposition copper layer b1 is directly used as a part or all of the bonding surface of the first bonding structure 11, and is bonded to the second bonding structure 12.

Refer to FIG. 15. In some possible implementations, the first middle barrier layer c1 may be disposed between the first electrochemical plating copper layer a1 and the first physical vapor deposition copper layer b1. In this case, impact of the crystal phase structure (BR) at the first electrochemical plating copper layer a1 on the crystal phase of the first physical vapor deposition layer b1 can be reduced by using a blocking function of the first middle barrier layer c1. In this way, the high proportion of the copper (111) crystal surface at the first physical vapor deposition layer b1 can be ensured.

Certainly, based on an actual requirement, the concave part may be disposed on the surface of the first electrochemical plating copper layer a1, or no concave part may be disposed on the surface of the first electrochemical plating copper layer a1. This is not limited in this application.

For disposing of the first barrier layer 21, the first seed crystal copper layer 22, the first electrochemical plating copper layer a1, the first physical vapor deposition copper layer b1, the first middle barrier layer c1, and the like in Embodiment 3, refer to the descriptions in Embodiment 1. Details are not described herein again.

For example, Embodiment 3 further provides a chip package structure manufacturing method. As shown in FIG. 16, the manufacturing method includes the following steps.

Step 31: Provide the first chip D1, and form the first dielectric layer 100 on the surface of the first chip D1, as shown in FIG. 14.

Step 32: Sequentially form the first barrier layer 21 and the first seed crystal copper layer 22 at the first dielectric layer 100, as shown in FIG. 14.

Step 33: Manufacture the first electrochemical plating copper layer a1 on the surface of the first seed crystal copper layer 22 through the electrochemical plating process, and manufacture the first physical vapor deposition copper layer b1 on the surface of the first electrochemical plating copper layer a1 through the physical vapor deposition process, to form the first copper structure 23, as shown in FIG. 14.

Certainly, in some other possible implementations, in step 33, after the first electrochemical plating copper layer a1 is formed, the first middle barrier layer c1 may be first formed on the surface of the first electrochemical plating copper layer a1, and then the first physical vapor deposition copper layer b1 is formed on the surface of the first middle barrier layer c1, to form the first copper structure 23.

Step 34: Bond the first chip D1 to the second copper bonding structure 12 in the second chip D2 by using the first copper structure 23 in the first copper bonding structure 11, with reference to FIG. 1 and FIG. 14.

For the foregoing manufacturing method (step 31 to step 34), refer to the related descriptions of the manufacturing method (step 11 to step 14) in Embodiment 1. Details are not described herein again.

### Embodiment 4

Different from the hybrid bonding used in the chip package structure in Embodiment 2, a chip package structure provided in Embodiment 4 uses a copper-copper direct bonding connection.

In Embodiment 4, as shown in FIG. 1, the chip package structure includes the first chip D1 and the second chip D2, and the first chip D1 and the second chip D2 are connected through copper-copper direct bonding.

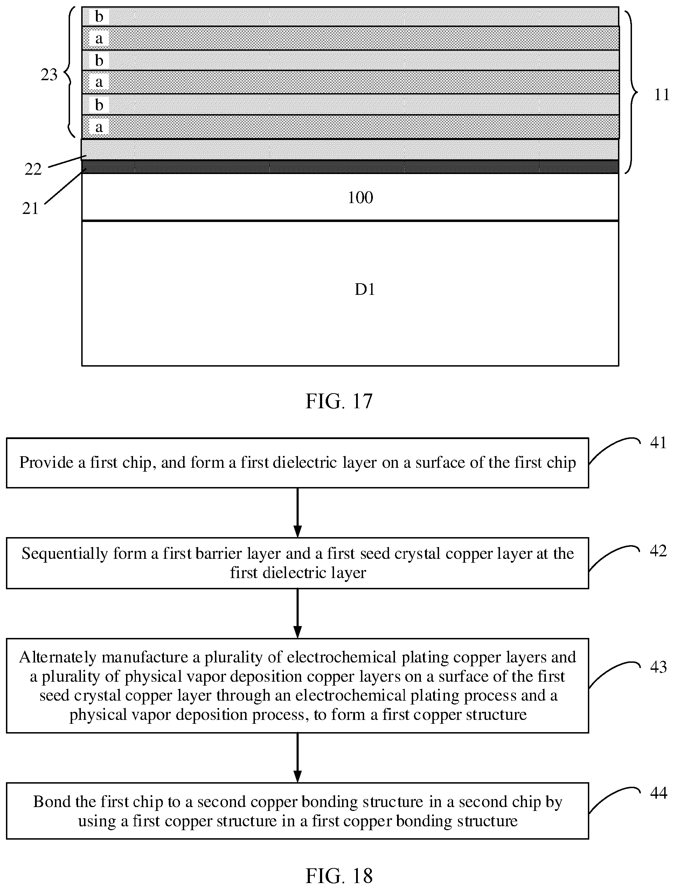

Refer to FIG. 17. The first dielectric layer 100 is disposed on the first chip D1, and the first barrier layer 21, the first seed crystal copper layer 22, and the first copper structure 23 are sequentially disposed on the surface of the first dielectric layer 100 from bottom to top. The first copper structure 23 includes a plurality of electrochemical plating copper layers a and a plurality of physical vapor deposition copper layers b that are alternately disposed in sequence on the surface of the first seed crystal copper layer 22.

For disposing of the first barrier layer 21, the first seed crystal copper layer 22, the first electrochemical plating copper layer a1, the plurality of physical vapor deposition copper layers b, the plurality of physical vapor deposition copper layers b, and the like in Embodiment 4, refer to the descriptions in Embodiment 2. Details are not described herein again.

For example, Embodiment 4 further provides a chip package structure manufacturing method. As shown in FIG. 18, the manufacturing method includes the following steps.

Step 41: Provide the first chip D1, and form the first dielectric layer 100 on the surface of the first chip D1, as shown in FIG. 17.

Step 42: Sequentially form the first barrier layer 21 and the first seed crystal copper layer 22 at the first dielectric layer 100, as shown in FIG. 17.

Step 43: Alternately manufacture the plurality of electrochemical plating copper layers a and the plurality of physical vapor deposition copper layers b on the surface of the first seed crystal copper layer 22 through the electrochemical plating process and the physical vapor deposition process, to form the first copper structure 23, as shown in FIG. 17.

Step 44: Bond the first chip D1 to the second copper bonding structure in the second chip D2 by using the first copper structure 23 in the first copper bonding structure 11, with reference to FIG. 1 and FIG. 17.

For the foregoing manufacturing method (step 41 to step 44), refer to the related descriptions of the manufacturing method (step 21 to step 24) in Embodiment 2. Details are not described herein again.

In conclusion, the new bonding structure used in the chip package structure provided in the foregoing embodiments of this application is implemented based on the ECP process and the PVD process, and can increase the proportion of the copper (111) crystal surface on the bonding surface of the bonding structure based on an existing device without using a new machine or a special electroplating cavity. In addition, a manufacturing manner of the new bonding structure has advantages of a simple process and low costs, and the new bonding structure has an important industrial production value.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a first chip and a first bonding structure disposed on the first chip; and
a second chip and a second bonding structure disposed on the second chip, wherein
the first bonding structure comprises a first barrier layer, a first seed crystal copper layer, and a first copper structure that are sequentially disposed, the first barrier layer is closer to the first chip than the first copper structure, and the first bonding structure is bonded to the second bonding structure by using the first copper structure;
the first copper structure comprises a first copper layer and a second copper layer that are sequentially disposed at the first seed crystal copper layer, the first seed crystal copper layer is in contact with the first copper layer, the first copper layer is an electrochemical plating copper layer, and the second copper layer is a physical vapor deposition copper layer; and
a surface of a side that is of the first copper structure and that is away from the first chip comprises at least a part of the physical vapor deposition copper layer.

2. The chip package structure according to claim 1, wherein
the second copper layer is in contact with the second bonding structure.

3. The chip package structure according to claim 2, wherein
a surface of a side that is of the first copper layer and that is away from the first chip has a first concave part, and the second copper layer covers the surface of the side that is of the first copper layer and that is away from the first chip.

4. The chip package structure according to claim 2, wherein
a surface of a side that is of the first copper layer and that is away from the first chip has a first concave part; and
the first copper structure further comprises a middle barrier layer, and the middle barrier layer is located between the first copper layer and the second copper layer.

5. The chip package structure according to claim 3 or 4, wherein a thickness of the second copper layer ranges from 5 nm to 70 nm.

6. The chip package structure according to claim 1, wherein
the first copper structure further comprises a plurality of third copper layers and a plurality of fourth copper layers that are alternately disposed in sequence on a side that is of the second copper layer and that is away from the first chip;
the third copper layer is an electrochemical plating copper layer, and the fourth copper layer is a physical vapor deposition copper layer; and
in the plurality of third copper layers and the plurality of fourth copper layers, a film layer that is in contact with the second copper layer is the third copper layer, and a film layer that is farthest away from the first chip is the fourth copper layer.

7. The chip package structure according to claim 6, wherein
a thickness of the third copper layer is less than or equal to 3000 Å.

8. The chip package structure according to any one of claims 1 to 7, wherein
the first seed crystal copper layer is a physical vapor deposition copper layer.

9. The chip package structure according to any one of claims 1 to 8, wherein
the first barrier layer comprises one or more of Ta, TaN, TaSiN, and TaSi_{0.10}N_{0.57}.

10. The chip package structure according to any one of claims 1 to 9, wherein
surface roughness of the first barrier layer is less than 20 nm.

11. The chip package structure according to any one of claims 1 to 10, wherein
surface roughness of a first dielectric layer is less than 1 nm.

12. The chip package structure according to any one of claims 1 to 11, wherein
the chip package structure further comprises the first dielectric layer, and the first dielectric layer is disposed on a surface of the first chip; and
the first bonding structure is a bonding layer disposed on a side that is of the first dielectric layer and that is away from the first chip.

13. The chip package structure according to any one of claims 1 to 11, wherein
the chip package structure further comprises the first dielectric layer; and
the first dielectric layer is disposed on a surface of the first chip, a plurality of first trenches are disposed at the first dielectric layer, and the first bonding structure is a bonding contact disposed in the first trench.

14. The chip package structure according to any one of claims 1 to 13, wherein
the second bonding structure comprises a second barrier layer, a second seed crystal copper layer, and a second copper structure that are sequentially disposed, the second barrier layer is closer to the second chip than the second copper structure, and the second copper structure is bonded to the first copper structure;
the second copper structure comprises a fifth copper layer and a sixth copper layer that are sequentially disposed at the second seed crystal copper layer, and the fifth copper layer is in contact with the second seed crystal copper layer; and
the fifth copper layer is an electrochemical plating copper layer, and the sixth copper layer is a physical vapor deposition copper layer.

15. The chip package structure according to claim 14, wherein
disposing structures of the second bonding structure and the first bonding structure are the same.

16. The chip package structure according to any one of claims 1 to 13, wherein
the second bonding structure comprises a second barrier layer, a second seed crystal copper layer, and a second copper structure that are sequentially disposed; and
the second barrier layer is closer to the second chip than the second copper structure, the second copper structure is an electrochemical plating copper layer, and the second copper structure is bonded to the first copper structure.

17. A chip package structure manufacturing method, comprising:
providing a first chip, and sequentially forming a first barrier layer and a first seed crystal copper layer on the first chip;
manufacturing a first copper structure on a surface of the first seed crystal copper layer through a physical vapor deposition process and an electrochemical plating process, to form a first copper bonding structure, wherein a surface of a side that is of the first copper structure and that is away from the first chip comprises at least a part of a physical vapor deposition copper layer; and
bonding the first chip to a second copper bonding structure on a second chip by using the first copper structure in the first copper bonding structure.

18. The chip package structure manufacturing method according to claim 17, wherein
the manufacturing a first copper structure on a surface of the first seed crystal copper layer through a physical vapor deposition process and an electrochemical plating process, to form a first copper bonding structure comprises:
manufacturing a first copper layer on the surface of the first seed crystal copper layer through the electrochemical plating process, and forming a first concave part on a surface of the first copper layer; and manufacturing a second copper layer on the surface of the first copper layer through the physical vapor deposition process, to form the first copper structure; or
manufacturing a first copper layer on the surface of the first seed crystal copper layer through the electrochemical plating process, and forming a first concave part on a surface of the first copper layer; and manufacturing a middle barrier layer on the surface of the first copper layer, and manufacturing a second copper layer on a surface of the middle barrier layer through the physical vapor deposition process, to form the first copper structure; or
alternatively manufacturing a plurality of copper layers on the surface of the first seed crystal copper layer through the electrochemical plating process and the physical vapor deposition process, to form the first copper structure.

19. The chip package structure manufacturing method according to claim 17 or 18, wherein
the providing a first chip, and sequentially forming a first barrier layer and a first seed crystal copper layer on the first chip comprises:
providing the first chip, and forming a first dielectric layer on a surface of the first chip; and
sequentially forming the first barrier layer and the first seed crystal copper layer on a surface of the first dielectric layer.

20. The chip package structure manufacturing method according to claim 17 or 18, wherein
the providing a first chip, and sequentially forming a first barrier layer and a first seed crystal copper layer on the first chip comprises:
providing the first chip, forming a first dielectric layer on a surface of the first chip, and forming a plurality of first trenches at the first dielectric layer; and
sequentially forming the first barrier layer and the first seed crystal copper layer in the first trench.

21. An electronic device, comprising a printed circuit board and the chip package structure according to any one of claims 1 to 16, wherein the chip package structure is electrically connected to the printed circuit board.
